# EUROPEAN PATENT APPLICATION

(11) **EP 4 250 379 A1**
(43) Date of publication of application: **27.09.2023**
(21) Application number: 22181167.2
(22) Date of filing: 27.06.2022
(51) Int. Cl.: H01L 33/00, H01L 33/46, H01L 33/50, H01L 33/60, H01L 25/075, H01L 25/16

(54) **AN OPTOELECTRONIC DEVICE WITH COLOR CONVERSION AND WITH CONFORMAL DBR AND AN ASSOCIATED FABRICATION METHOD**

(30) Priority: 24.03.2022 EP 22164102
(71) Applicant: Micledi Microdisplays BV, 3000 Leuven (BE); Imec VZW, 3001 Leuven (BE); Universiteit Gent, 9000 Gent (BE)
(72) Inventor: STEUDEL, Soeren, 3020 Herent (BE); VAN STEENBERGE, Geert, 9040 Sint-Amandsberg (BE)
(74) Representative: Körfer, Thomas

(57) **Abstract**

An optoelectronic device (100) comprises a semiconductor light-emitting component (101) capable of emitting light at a first wavelength, a cavity (107) filled with a semiconductor wavelength conversion material (103) disposed in a path of the light emitted by the semiconductor light-emitting component (101) for converting the first wavelength into a second wavelength and a first multilayer interference reflector (105) provided at a bottom of the cavity (107) directed to the light-emitting component (101). The first multilayer interference reflector (105) is configured to be transmitive for the first wavelength and reflective for the second wavelength and a second multilayer interference reflector (106) is provided at a top (106') and sidewalls (106") of the cavity (107). The second multilayer interference reflector (106) is configured to be transmitive for the second wavelength and to be reflective for the first wavelength. An associated method of making the optoelectronic device is also provided.

## Description

The invention relates to display technologies, particularly, relates to micro light emitting devices (pLEDs) with color conversion and an associated method of making the same.

Full-color technologies applied to light-emitting diode devices have advanced significantly. Commonly, full-color technologies include the use of multi-layer structures, color conversion, juxtaposed pixels, color filters, etc. To apply the color conversion method, light emitted by certain active material is used as excitation to excite color conversion material to emit light with different colors or wavelengths. In this way, full-color light can be produced by using the same epitaxial wafer.

US patent application US 2019/0123033 A1 discloses combining red, green, and blue-emitting LEDs on a single die. LED pixels form thin pillars, each of them separated by a metal layer. The metal layer between the pillars acts as a mechanical support and defines the shape of the color converter material. A pixel pillar includes a p-type layer, an active layer, an n-type layer, a distributed Bragg reflector (DBR) that passes light of a first color and reflects other colors, and a down converter material. The down converter converts the first color to a desired color. An optional DBR layer overlays the down converter material, which reflects the first color and passes the desired color. The single die comprises an array of mechanically isolated LED pillars, each capable of producing any desired color.

However, the resulting device will have metal layers deposited in the trenches between the pixel pillars. Such a device is not suitable for use of high-viscous or high-loading wavelength conversion material by patterning. Further, the aspect ratio and the form factor are limited due to the presence of the separation metal layer between the pixel pillars. In addition, the lifetime of the wavelength conversion layer is limited without a conformal coating around its contour and can be affected during the deposition of the metal layer.

Accordingly, an object of the invention is to provide an optoelectronic device, a display device comprising the optoelectronic device and a method of making the optoelectronic device facilitating the fabrication, increasing the yield and increasing the efficiency of light emission.

The object is solved by the features of the first independent claim for the optoelectronic device, by the features of the second independent claim for the display device, and the third independent claim for the method of making the optoelectronic device.

According to a first aspect of the present invention, an optoelectronic device is provided. The optoelectronic device comprises, a semiconductor light-emitting component capable of emitting light at a first wavelength and a cavity filled with a semiconductor wavelength conversion material disposed in a path of the light emitted by the semiconductor light-emitting component for converting the first wavelength into a second wavelength. It also comprises a first multilayer interference reflector provided at a bottom of the cavity directed to the light-emitting component, wherein the first multilayer interference reflector is configured to be transmitive for the first wavelength and is reflective for the second wavelength. Particularly, the first multilayer interference reflector is configured to be transmitive for the shorter wavelength and is reflective for higher wavelength. The optical device further comprises a second multilayer interference reflector provided at a top and sidewalls of the cavity, wherein the second multilayer interference reflector is configured to be transmitive for the second wavelength and to be reflective for the first wavelength.

Therefore, the proposed device has an encapsulated wavelength conversion material that ensures a longer lifetime. The device of the invention is suitable for providing high-viscous and high-loading wavelength conversion material by patterning. DBR is provided on the top and sidewalls are made of the wavelength conversion material. This serves to optically isolate each wavelength conversion material. Therefore, a further optical isolating material is not necessary. Further, DBR is deposited on the top and sidewalls are transmissive for the converted light. So optical isolation between different LEDs is only provided compared to the LEDs without conversion material such as green compared to blue but not compared to red. Therefore, the optoelectronic device of the invention has a pixel size below 5 µm, preferably below 3 µm. Advantageously and efficiently, the form factor and pixel density are improved. The efficiency is improved because the first wavelength is reflected back into the cavity also at the sidewalls but light with the second wavelength can also escape from the cavity at the sidewalls. In case it is not desired, the DBR could be designed taking into account the angle of the light with respect to the normal or near-normal of the surface.

Preferably, the wavelength conversion material comprises quantum dots or elements of nanophosphor. Quantum dots (QDs) have the advantages of nanometer size, a high quantum yield, a broad absorption spectrum, and a narrow emission spectrum. Advantageously, improving the color conversion efficiency of the device.

Preferably, the first multilayer interference reflector and the second multilayer interference reflector are alternating layers of low refractive index material and high refractive index material. The low refractive index material preferably comprises SiO₂ or Al₂O₃. The high refractive index material preferably comprises Al₂O₃, SiN, NbO₂, TaO₂, HfO₂, or TiOₓ. By tailoring the porosity of Al₂O₃ the effective refractive index is changed. For example, Al₂O₃ formed by pulse anodization can be either mild anodized or hard-anodized resulting in different porosities and thereby different refractive indices. Other suitable methods may also be employed to produce Al₂O₃ having different refractive indices. Therefore, alternating high and low refractive index Al₂O₃ layers behave as the multilayer interference reflector. Multilayer interference reflector is also known as DBR. The materials are not intended to be exhaustive.

Preferably, the number of alternating layer pairs is between 2 and 10, preferably between 3 and 8, most preferably between 4 and 6. The thickness layer pairs can be selected based on the required emission wavelength and/or emission angles of the device. The number of layer pairs is selected in order to achieve the required efficiency.

Preferably, the cavity has a lateral dimension less than 10 µm, preferably less than 5 µm, further preferably less than 3 µm. Thus, the form factor may be improved.

Preferably, a thickness of the first multilayer interference reflector and/or of the second multilayer interference reflector is between 500 nm to 1000 nm. Additionally or alternatively, a width of the second multilayer interference reflector is between 2000 nm and 3000 nm. Advantageously and efficiently, the device provides improved form factors.

Preferably, the top and the sidewalls further comprise a further outer layer of reflective or a light-absorbing material. The reflective material such as nickel, silver, gold, aluminum, titanium, or alloys thereof prevents crosstalk between each color-converting layer. Advantageously, this provides a further optical isolation between two optoelectronic devices of the invention.

Preferably, a color filter 108 is provided on the top multilayer interference reflector 106'. The color filter may be a specific filter.

According to a second aspect of the present invention, a display device is provided. The display device comprises a plurality of optoelectronic devices according to the first aspect of the invention provided side-by-side and configured to emit light of predetermined wavelength, and each pixel of the display comprises at least one of the optoelectronic devices according to the first aspect of the invention. Advantageously and efficiently, high pixel density and improved form factor are achieved.

According to a third aspect of the present invention, a method of making an optoelectronic device is provided. The method comprises a) depositing a first multilayer interference reflector over a semiconductor light-emitting component, b) depositing or patterning a semiconductor wavelength conversion material over the first multilayer interference reflector and in between contacts provided in the first multilayer interference reflector, and c) deposition of a second multilayer interference over the entire surface of the wavelength conversion material.

Preferably, the method further comprises making a plurality of the contacts in the first multilayer interference reflector by damascene or dual damascene and providing vias between at least one of the contacts of the first multilayer interference reflector and a contact of a wafer comprising driving elements, especially a CMOS wafer, by damascene, dual damascene or etching followed by deposition.

Preferably, the method further comprises depositing the first multilayer interference reflector layers and/or the second multilayer interference reflector layers by atomic layer deposition, chemical vapor deposition, or physical vapor deposition, whereby atomic layer deposition is preferred.

Preferably, the method further comprises repeating the depositing step a) or c) on the first multilayer interference reflector or the second multilayer interference reflector, respectively, at least one more time. Advantageously and efficiently, the desired number of layer pairs are obtained with high accuracy.

Preferably, the method further comprises depositing or patterning the semiconductor wavelength conversion material by lithography or laser-induced forward transfer (LIFT). LIFT might be Blister-actuated LIFT or Laser release LIFT. Pre-patterning of the Quantum Dot (QD) photoresist, which is photoresist comprising Quantum Dots (QDs), is provided by lithography techniques. Advantageously and efficiently, a high-viscous and ultra-high loading of the QDs is obtained and the wavelength conversion material has high-resolution QD patterns.

Preferably, the method further comprises patterning the first multilayer interference reflector and/or the second multilayer interference reflector by lithography or dry etching to remove at least a part of the first multilayer interference reflector and/or at least a part of the second multilayer interference reflector.

Preferably, the method further comprises steps for fabricating the semiconductor light-emitting device, such as etching an LED wafer to form mesas with a predetermined depth or less. The LED wafer comprises a substrate with a transparent conductive oxide layer and an active layer sandwiched between a first semiconductor layer and a second semiconductor layer is on the conductive oxide layer. The method comprises filling etched spaces on the LED wafer with an oxide, providing contacts on the mesas on the LED wafer by damascene, especially copper damascene, transferring the LED wafer to a CMOS wafer to form hybrid bonds, and etching or planarizing the substrate of the LED wafer to expose the conductive oxide layer. The first semiconductor layer and the second semiconductor layer may be either p-doped or n-doped, respectively. The active layer can be a quantum well layer. For example, the conductive oxide layer comprises indium tin oxide and the CMOS wafer has a thickness of 775 µm or less.

The first aspect, the second aspect, and the third aspect achieve the same advantages and effects.

Exemplary embodiments of the invention are now further explained with respect to the drawings by way of example only, and not for limitation. In the drawings:
- Fig. 1: shows an exemplary embodiment of an optoelectronic device according to the first aspect of the invention;
- Fig. 2A-B: show an exemplary embodiment of a LED wafer and a semiconductor light emitting component, respectively, in cross-sectional view;
- Fig. 3A-B: show an exemplary embodiment of a layer structure of a multilayer interference reflector and a corresponding optical performance spectrum;
- Fig. 4: shows an exemplary embodiment of the optoelectronic device structure of the invention;
- Fig. 5: shows an exemplary embodiment of tight-pitched display arrangement of the invention according to the second aspect of the invention;
- Fig. 6: shows an exemplary flow diagram for a method according to the third aspect of the invention;
- Fig. 7A-G: show process flow diagrams of an exemplary embodiment of the method of the invention;
- Fig. 8A: shows an exemplary embodiment of the optoelectronic device with a color filter; and
- Fig. 8B: shows a transmission spectrum of the color filter of Fig. 8A.

Reference will now be made in detail to the embodiments of the present invention and examples of which are illustrated in the accompanying drawings. However, the following embodiments of the present invention may be variously modified and the range of the present invention is not limited to the following embodiments. Reference signs for similar entities in different embodiments are partially omitted.

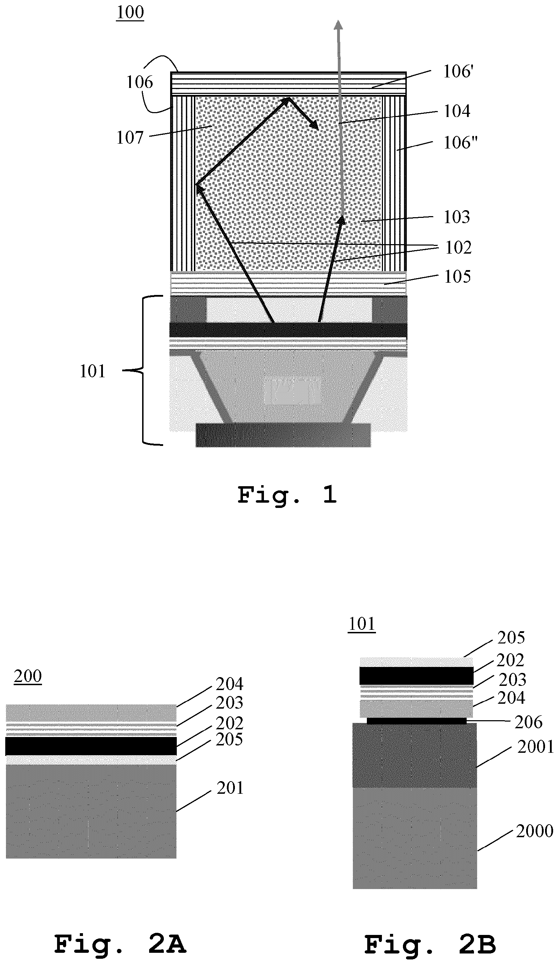

In Fig. 1, an exemplary embodiment of the optoelectronic device according to the first aspect of the invention is illustrated. A semiconductor light-emitting component 101 capable of emitting light of first wavelength 102 is provided. A cavity 107 is filled with a semiconductor wavelength conversion material 103 disposed in the path of the light 102 emitted by the semiconductor light-emitting component 101. A first multilayer interference reflector 105 is provided at a bottom of the cavity 107. The first multilayer interference reflector 105 is configured to be transmitive to the first wavelength 102 and reflective to the second wavelength 104. In particular, the first multilayer interference reflector is configured to be transmitive for the shorter wavelength and is reflective for higher wavelength. A second multilayer interference reflector 106 is provided at a top 106' and sidewalls 106" of the cavity 107. The second multilayer reflector 106 is configured to be transmitive for the second wavelength 104 and to be reflective for the first wavelength 102.

The material of the cavity 107 over the light emitting component 101 is filled with wavelength conversion layer and in the example comprises quantum dots (QDs) and/or elements of nanophosphor. The QDs are excited by light to emit light with different wavelengths based on their size shape, and composition. In this way, the emission wavelength can be adjusted by changing these parameters, which can be used to realize a full-color display for example for micro-LEDs. QDs are usually made of II-VI group compounds, III-V group compounds, or I-III-VI compounds such as CdSe, InP, and CuInS₂. Elements of nanophosphor may be incorporated in QDs to further improve the color rendering property. Advantageously, the wavelength conversion material may be provided as a solid layer or a colloidal layer. QDs are also suitable to be excited by a blue or ultraviolet (UV) LED. For example, QDs composed of CdSe, ZnS, and CdS, which can emit light with wavelengths of 450 nm, 520 nm, and 630 nm, respectively, when excited by 365 nm UV light.

In the example the cavity 107 has a lateral dimension less than 10 µm, preferably less than 5 µm, further preferably less than 3 µm. By changing the composition filled in the cavity 107 and the dimension of the cavity 107, efficient emission can be achieved.

The cavity 107 is conformally formed by the first multilayer interference reflector 105 and the second multilayer interference reflector 106. The first multilayer interference reflector 105 is provided at the bottom i.e., between the cavity 107 and the light emitting component 101. The second multilayer interference reflector 106 is provided at the top 106' and the sidewalls 106" of the cavity 107. The top 106' and the sidewalls 106" can also be coated as a single uniform coating, covering or creating both: the top and the sidewalls of the cavity 107. In the example, this is made in a way that the first multilayer interference reflector 105 limits the lower dimension of the cavity 107 and that the second multilayer interference reflector 106 limits the upper and sidewise dimensions of the cavity 107. The first wavelength 102 entering the cavity 107 from the light emitting component 101 is converted to a second wavelength 104 by the wavelength conversion material 103 provided in the cavity 107. The second wavelength 104 is transmitted through the top 106'. While the sidewalls 106" and the top 106' reflect the first wavelength 102.

If the second multilayer interference reflector 106 is only provided on the top 106', like in the background art, the first wavelength 102 and/or the second wavelength 104 will be lost via the sides walls. Moreover, a plurality of neighboring wavelength conversion materials must be optically isolated in order to avoid cross talking. The device of the invention overcomes leaky emission (referred to light with the color converted, namely the light of second wavelength 102) by providing the second multilayer interference reflector 106 not only at the top 106' but also of the sidewalls 106", while providing the improved form factor. A further advantage of the DBR sidewalls 106" is elimination of the metal layer completely or partially.

The first multilayer interference reflector 105 and the second multilayer interference reflector 106 are made of alternated layers 1501, 1502 of high refractive index material 1051, and low refractive index material 1502. The light is partially refracted, reflected, and transmitted at each interface. The layer thickness and the layer refractive indexes of the DBR define whether the interference among reflected/transmitted beams is constructive or destructive at a specific wavelength and in turn, this defines the spectrum for which it is reflective or transmitive. The high refractive index material 1051 preferably comprises Al₂O₃, SiN, NbO₂, TiO₂, HfO₂, and/or TiOₓ and/or the low refractive index material 1052 preferably comprises SiO₂ or Al₂O₃.

In Fig. 2A-B, an exemplary embodiment of a LED wafer 200 and a semiconductor light emitting component 101 are provided in cross-sectional views. The epitaxial wafer (not shown) comprises a substrate, a semiconductor layer such as n-GaN, an active layer such as a multi-quantum well (MQW), another semiconductor layer such as p-GaN, a transparent conducting oxide such as ITO, and a top layer of bonding dielectric. Optionally, a buffer layer on top of the substrate made of the same material as a first semiconductor layer is provided. This epitaxial wafer is transferred onto a blank wafer. The substrate of the epitaxial wafer is removed to expose the first semiconductor layer. The resulting wafer is referred to as an LED wafer 200 hereinafter.

Fig. 2A shows a cross-sectional view of the LED wafer 200. The LED wafer 200 comprises a substrate 201, an ITO layer 205, a first semiconductor layer 202, a second semiconductor layer 204, and an active layer 203 sandwiched between the first semiconductor layer 202 and the second semiconductor layer 204. The first semiconductor layer 202 may be p-GaN and the second semiconductor layer 204 may include n-GaN. The active layer 203 may include the MQW structure. Optionally, the buffer layer of the same material as the second semiconductor layer 204 is provided (not shown in Fig. 2A).

Fig. 2B shows a cross-sectional view of the LED wafer 200 flip-chip bonded at the contacts 206 to a wafer comprising driving elements, such as transistors, preferably a Si-CMOS wafer 2000. The substrate 201 of the light-emitting wafer 200 is removed to expose the ITO layer 205. The substrate 2000 of the CMOS wafer may be a 300 mm Si-wafer, preferably 775 µm or less. The resulting component is referred to as semiconductor light emitting component 101.

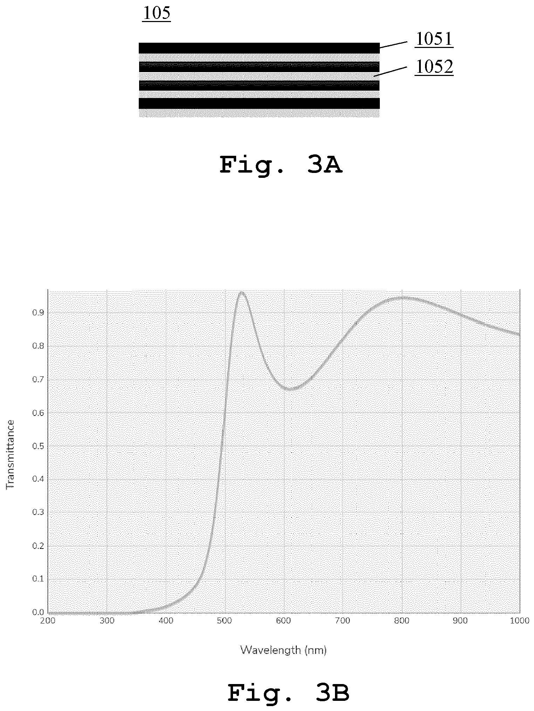

Fig. 3A shows an exemplary cross-sectional view of the first multilayer interference reflector 105, 106 and Fig. 3B shows a transmission spectrum of the first multilayer interference reflector 105 shown in Fig. 3A.

An example multilayer interference reflector 105, 106 structure shown in Fig. 3A having four-layer pairs. The multilayer interference reflector may be a distributed Bragg reflector. Fig. 3A shows a multilayer interference reflector formed by alternately stacking of TiO₂/SiO₂ layers. The TiO₂ layer has a thickness of 55 nm and the SiO₂ has a thickness of 30 nm. The corresponding transmittance spectrum for a DBR is shown in Fig. 3B. The spectrum shows the transmittance of the first DBR/multilayer interference reflector 105 to transmit above 520 nm and reflect below 460 nm.

The thickness of the first multilayer interference reflector 105 and/or the second multilayer interference reflector 106 is between 500 nm to 1000 nm. The width of the first multilayer interference reflector 105 and/or the second multilayer reflector 106 is between 2000 nm and 3000 nm. The thickness and number of layer pairs of the first DBR and/or second DBR determine its optical characteristic, especially the quality factor Q. The width of the enclosed cavity 107 may match the width of underlying light emitting component 101.

The sidewalls 106" of the cavity 107 comprise a further optional outer layer of reflective material or light absorbing material. The reflection material may include, for example, a metal such as Ag, Al, Cr, or Ni or their oxides and/or nitrites. The metal reflection layer may include a multilayer structure that comprises a first layer of material having relatively low reflectance metal such as Cr, Ni, or Ti and the second layer of material having a relatively high reflectance such as Ag or Al. The light absorbing layer may include, for example, carbon nanotubes (CNTs), graphene, aluminum gallium nitride (AIGaN), indium gallium nitride (InGaN), InGaN/GaN superlattice, AIGaN/GaN superlattice, titanium nitride (TiN), tungsten nitride (WN), or boron nitride (BN), but the present disclosure is not limited thereto.

Therefore, each color-converting device may be a further optically isolating layer in addition to the sidewalls 106". The light absorbing material or the reflective material may prevent the crosstalk between each of the color converting devices. Advantageously it also improves the contrast.

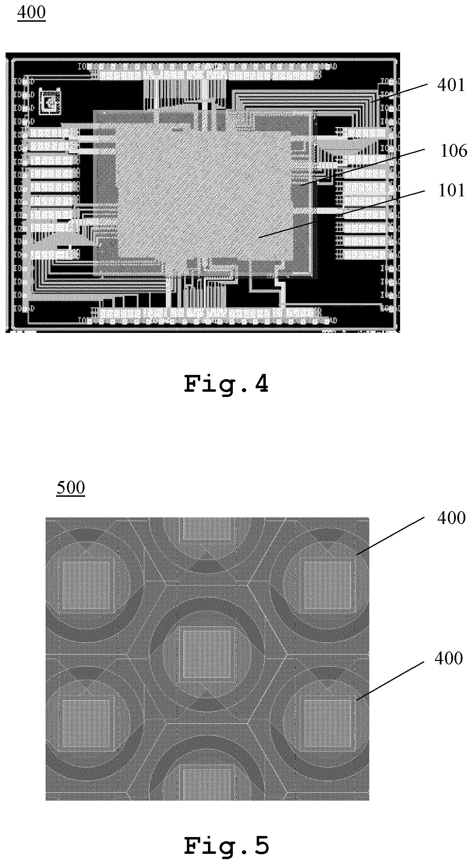

Fig. 4 shows a top view of an example of the optoelectronic device 400 of the invention. The light emitting component 101 is seen to be covered by the second multilayer interference reflector 106. Inherently, device 400 comprises the first multilayer interference reflector 105 (not shown in this view) and the sidewalls 106" (not marked in Fig. 4) made of the same material as the top 106' second multilayer interference reflector 106. The optoelectronic device 100 is bonded to an integrated circuit for driving it. The integrated circuit may be an application-specific integrated circuit (ASIC) is CMOS technology.

Fig. 5 shows a display device 500 comprising a plurality of the optoelectronic devices 400. Fig. 5 shows an exemplary pixel layout of the device 500. However, the display device 500 may have any pixel layout. The invention enables tight-pitched pixel arrangements because of the inherently isolated optoelectronic devices 400.

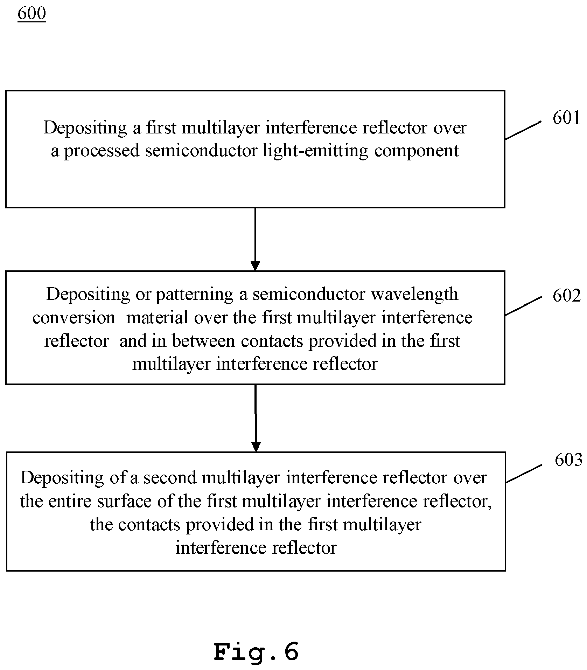

In Fig. 6, an exemplary embodiment of the method according to the third aspect of the invention is illustrated as a flow diagram. The method of making an optoelectronic device comprises the steps of a) 601 depositing a first multilayer interference reflector 105 over a semiconductor light-emitting component 101, b) 602 depositing or patterning a semiconductor wavelength conversion material 103 over the first multilayer interference reflector 105 and in between contacts 7001 provided in the first multilayer interference reflector 105, and c) 603 deposition of a second multilayer interference reflector 106 over the entire surface of the wavelength conversion material 103.

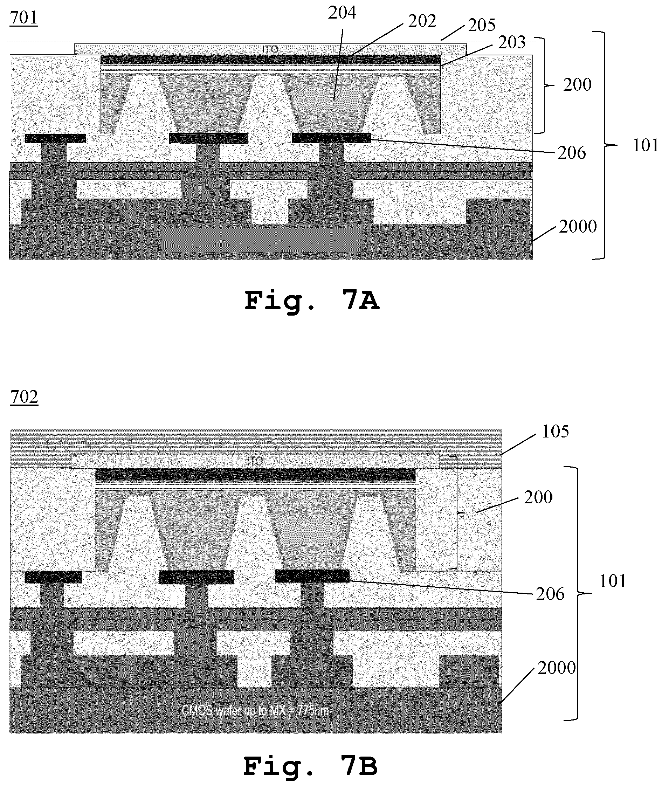

In Fig. 7A-G exemplary embodiments of process flow diagrams of the method steps according to the third aspect of the invention are provided.

Fig. 7A shows the light emitting component 101 comprising the LED wafer 200 and the driving circuits on a substrate 2000. The layer structure of the LED wafer 200 and the semiconductor light emitting component 101 are discussed in Fig. 2A and Fig. 2B, respectively.

The detailed fabrication steps of an LED wafer are not shown here. The epitaxial wafer (not shown) comprises a substrate, a semiconductor layer such as n-GaN, an active layer such as a multi-quantum well (MQW), another semiconductor layer such as p-GaN, a transparent conducting oxide such as ITO, and a top layer of bonding dielectric as shown in Fig. 2A. Optionally, a buffer layer on top of the substrate made of the same material as a first semiconductor layer is provided. The epitaxial wafer is transfer to the blank wafer for example, by wafer-to-wafer transfer technology. The substrate of the epitaxial wafer is removed to expose the first semiconductor layer by any suitable method known in the art. The resulting LED wafer 200 is flip-chip bonded to a CMOS wafer to produce a semiconductor light emitting component 101 and the layer structure as shown in Fig. 2A.

In the example the steps for fabricating the semiconductor light emitting component 101 involves: a) etching an LED wafer 200 to form mesas with a predetermined depth or less, b) filling etched spaces on the LED wafer 200 with an oxide, c) providing contacts 206 on the mesas on the LED wafer 200 for example by damascene especially by copper damascene, d) transferring the LED wafer 200 in a flip-chip manner to a wafer comprising driving elements, preferably a CMOS wafer to form hybrid bonds and e) etching or planarizing the substrate of the LED wafer 200 to expose the conductive oxide layer 205. The LED wafer 200 bonded to the CMOS wafer is shown in Fig. 7A. This resulting component is called semiconductor light emitting component 101, 701 within this application.

Fig. 7B shows a step of depositing a first multilayer interference reflector 105 over a semiconductor light emitting component 101, 701. The first multilayer interference reflector 105 preferably is deposited by atomic layer deposition (ALD), chemical vapor deposition (CVD), physical vapor deposition (PVD), or electron beam evaporation, thereby ALD is most preferred. Several layer pairs comprising a high refractive index material 1051 and a low refractive index material 1052 are deposited. Based on the required optical properties, especially quality factor Q, the number of layer pairs is determined. The atomic layer deposition is the most preferred method to deposit the first multilayer interference reflector 105 and the second multilayer interference reflector 106 of the invention.

The ALD deposition film is grown on a substrate by exposing its surface to alternate gaseous species. ALD allows multiple precursors for different film deposition to be loaded at the same time. Some of the advantages of ALD are controlled film production to atomically specified thickness, thickness uniformity, straightforward deposition of a group of different multilayer structures, etc. Different ALD methods have deposition temperature range of 150 - 350°C without comprising the film quality. The substrate dimensions are not critical for the ALD process. Therefore, the multilayer interference reflectors 105, 106 can be made by the ALD method by once loading the semiconductor light emitting component 101 in the ALD deposition chamber along with the required precursors such as SiO₂/TiO₂.

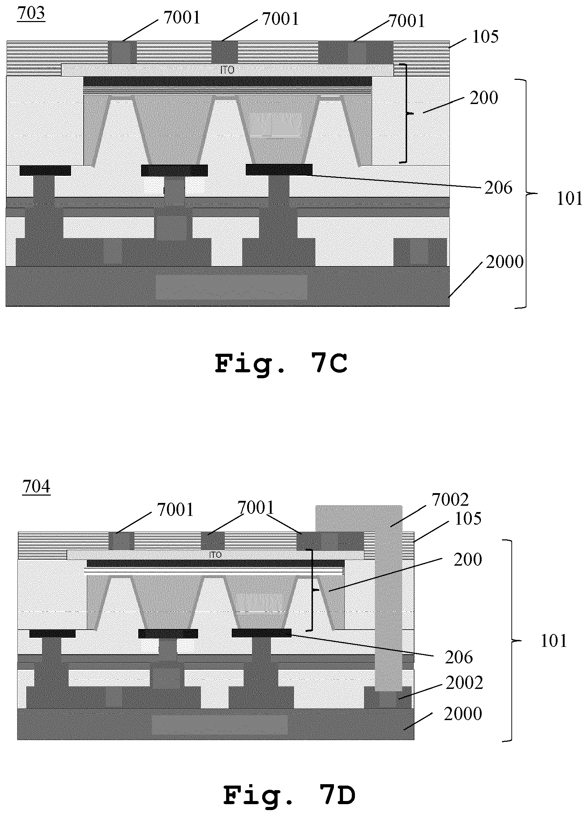

Fig. 7C shows a step of providing a plurality of contacts 7001 in the first multilayer interference reflector 105 by damascene such as Cu-damascene or etching such as plasma reactive ion etching. These methods advantageously do not affect the structure or properties of the multilayer interference reflector 105.

Fig. 7D shows providing at least a via 7002 between at least one of the contacts 7001 in the first multilayer interference reflector 105 and a contact 2002 of the CMOS wafer 2000. The via 7001 may be made by damascene or etching and deposition processes.

The damascene process makes use of existent interlayer dielectrics in which the vias and trenches for conduction paths are etched. Subsequently, copper is deposited, e.g. by chemical vapor deposition, CVD, or by physical vapor deposition, PVD, with reflow, or in electrochemical/galvanic processes. Afterwards, the copper is planarized by CMP. The damascene process can be separated into a single and dual damascene process, both are supported by the presented process flow.

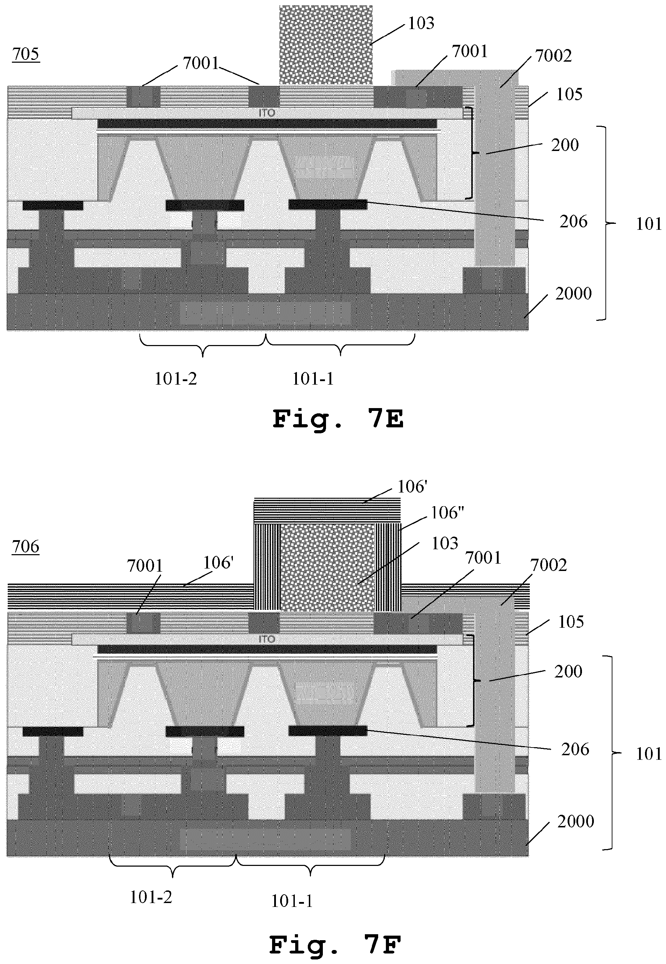

Fig. 7E shows a step of depositing or patterning a semiconductor wavelength conversion material 103 over the first multilayer interference reflector 105 and in between contacts 7001 provided in the first multilayer interference reflector 105. Lithography and/or laser-induced forward transfer (LIFT) does the depositing or patterning of the semiconductor wavelength conversion material 103.

Given the limitations of inkjet printing, the option to deposit patterned QD layers with LIFT technology as a versatile direct-write technique capable of printing high-resolution QD patterns (<5 µm, <1 fl) with increasing solid loading is most preferred.

LIFT is the most preferred process to deposit QDs here. LIFT is an additive laser direct-writing technique especially conceived for micropatterning applications. LIFT is a high-resolution single-step process to achieve micro-patterning or the partial deposition of solid or liquid material. The LIFT process has many advantages such as it does not introduce any impurities into the CMOS line and has good repeatability. Lasers such as pulsed lasers with pulse duration of femtosecond and nanosecond are generally preferred for the invention.

Two different LIFT methodologies are preferred: a blister-actuated LIFT process for printing fluid (uncured) QD-photoresist and a laser release LIFT process for transferring pre-patterned solid (cured) QD-photoresist. Lithography techniques may be used for pre-patterning of QD photoresists.

In Blister-actuated laser-induced forward transfer (BA-LIFT) fine jets of QD-photoresist are ejected from a thin donor film onto the microLED substrate, enabling high-resolution patterns to be printed. The fluid ejections are initiated by the rapid expansion of micrometer-sized blisters that form on a polymer (e.g. Polyimide) film underneath the QD-photoresist layer. The technique is ideally suited for printing sensitive QD materials, as the incoming laser pulse is absorbed in the blister forming polymer layer, preventing direct laser-material interaction with the sensitive QD material.

In laser release LIFT solid QD-photoresist lithographically a pattern on a planar glass substrate is released from the temporary glass carrier using a pulsed laser, enabling high-resolution patterning on microLED display substrates with surface topography. A so-called dynamic release layer (DRL) absorbs the incoming laser pulse and enables a material transfer after ablation of the DRL layer by sublimation and fragmentation.

Both above mentioned and other types of LIFT processes are supported in the presented process flow. For the lithographic pre-patterning of the QD-photoresist, both optical and imprint lithography will be employed. This approach allows for combining the main advantages of lithography and printing, potentially resulting in optimum layer uniformity and pattern resolution, despite the presence of surface topography.

In Fig. 7E QD layer deposition 103 over the one of the light emitting components 101 is shown as an example. This process can be repeated over a plurality of such light emitting components 101 in a repetitive and time-saving manner by LIFT. In Fig. 7E, only a single color conversion material 103 over one of the light emitting components 101 is shown. However, over each of the plurality of light emitting components 101, 101', the desired color conversion material 103 may be deposited. The deposited color conversion material 103 for each light emitting component 101 may be the same or different.

In Fig. 7F a second multilayer interference reflector 106 is deposited over the entire surface of the color conversion material 103 providing a top 106' and sidewalls 106" on the contour of the color conversion material 103. The second multilayer interference reflector 106 may be deposited by the same methods discussed for the first multilayer interference reflector 105. As mentioned with respect to Fig. 7E, when a plurality of color conversion materials 103 is provided over a plurality of light emitting components 101, the second multilayer interference reflectors 106 over the plurality of color conversion materials 103 can be deposited simultaneously.

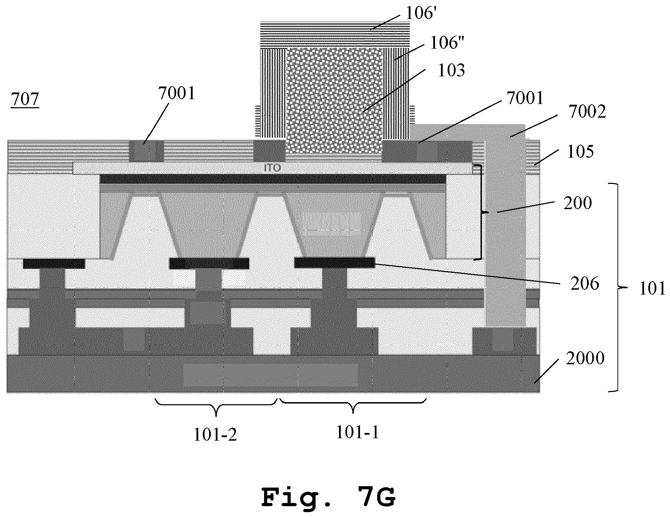

Fig. 7G shows a step of removal of the second multilayer interference reflector 106, for example, that covers the neighboring light emitting components 101' that does not have a color conversion material 103 yet. Dry etching may be used to remove the first multilayer interference reflector 105 or second multilayer interference reflector 106. Therefore, deposition of color conversion layer on each light emitting component 101, 101' may also be done sequentially.

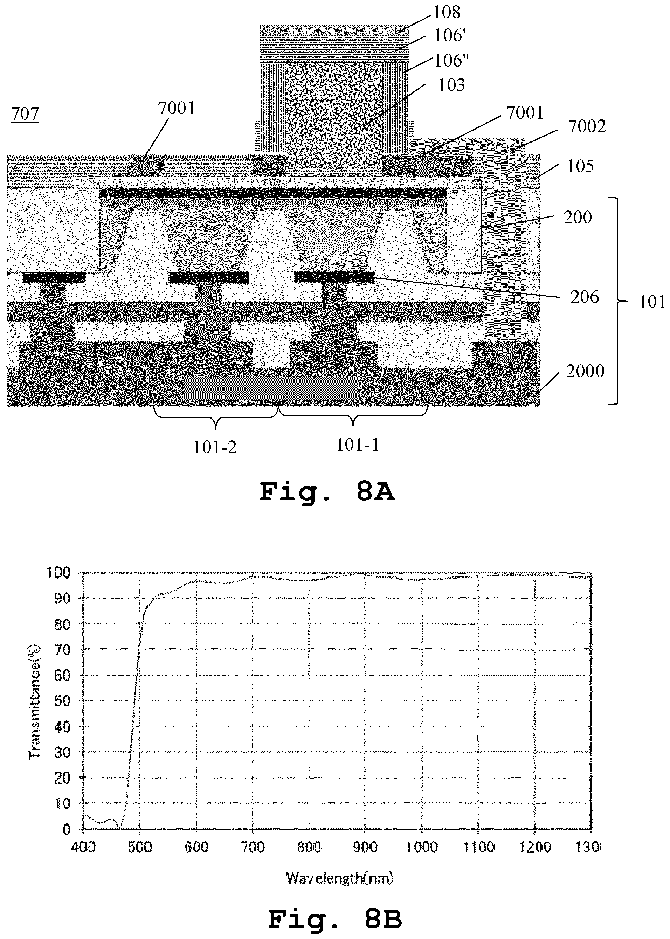

In Fig. 8A an exemplary embodiment of the optoelectronic device, a color filter is shown. The top DBR 106' shown in Fig. 7G shall suppress blue light leakage and allow the refection of the blue light back into the wavelength conversion material 103. Thus, the blue light again has the chance to be converted. However, DBR may not be perfect across all angles in suppressing the blue light. Therefore, limited blue light leakage may be observed, especially for angles around zero degrees of the top DBR 106'. For obtaining a complete suppression of the blue light, a color filter 108 may be additionally used on the top DBR 106' as shown in Fig. 8A. In order to suppress the blue light leakage the color filter used may be a yellow color filter. The yellow filter cuts off blue light (< 490 nm) and transmits green/red light. For an image sensor, a color mosaic may be used. A specific yellow color filter mosaic may be used on the top DBR 106'. Fig. 8B shows the transmission spectrum of the yellow color filter mosaic as an example.

This invention proposes an alternative way to reconstitute wafer structures, wherein a single ASIC or common monolithic integrated circuit comprises at least the first light-emitting device configured to emit light of a first color and a second light-emitting device configured to emit light of a second color. This approach can still be combined with the conventional wafer reconstitution to further improve the display device.

It is important to note that the indefinite article "a" or "an" does not exclude a plurality. Moreover, the description with respect to any of the aspects is also relevant with regard to the other aspects of the invention. Although the invention has been illustrated and described with respect to one or more implementations, equivalent alternations and modifications will occur to others skilled in the art upon the reading and understanding of this specification and the annexed drawings. In addition, while a particular feature of the invention may have been disclosed with respect to only one of several implementations, such features of the other implementations may be desired and advantageous for any given or particular application.

## Claims

1. An optoelectronic device (100) comprising,
a semiconductor light-emitting component (101) capable of emitting light at a first wavelength (102),
a cavity (107) filled with a semiconductor wavelength conversion material (103) disposed in a path of the light emitted by the semiconductor light-emitting component (101) for converting the first wavelength into a second wavelength,
a first multilayer interference reflector (105) provided at a bottom of the cavity (107) directed to the light-emitting component (101), wherein the first multilayer interference reflector (105) is configured to be transmitive for the first wavelength (102) and reflective for the second wavelength (104), and
a second multilayer interference reflector (106) provided at a top (106') and sidewalls (106") of the cavity (107), wherein the second multilayer interference reflector (106) is configured to be transmitive for the second wavelength (104) and to be reflective for the first wavelength (102).

2. The device (100) according to claim 1,
wherein the wavelength conversion material (103) comprises quantum dots and/or elements of nanophosphor.

3. The device (100) according to claim 1 or 2,
wherein the first multilayer interference reflector (105) and the second multilayer interference reflector (106) are alternating layers of a high refractive index material (1051) and a low refractive index material (1052),
wherein the high refractive index material (1051) comprises Al₂O₃, SiN, NbO₂, TaO₂, HfO₂ and/or TiOₓ and/or the low refractive index material (1052) comprises SiO₂ and/or Al₂O₃.

4. The device (100) according to any of claims 1 to 3,
wherein a number of alternating layer pairs (1051, 1052) is between 2 and 10, preferably between 3 and 8, most preferably between 4 and 6.

5. The device (100) according to any of claims 1 to 4,
wherein the cavity (107) has a lateral dimension less than 10 µm, preferably less than 5 µm, further preferably less than 3 µm.

6. The device (100) according to any of claims 1 to 5,
wherein a thickness of the first multilayer interference reflector (105) and/or of the second multilayer interference reflector (106) is between 500 nm to 1000 nm, and/or
wherein a width of the second multilayer interference reflector (106) is between 2000 nm and 3000 nm.

7. The device (100) according to any of claims 1 to 6,
wherein the top multilayer interference reflector (106') and the multilayer interference reflector sidewalls (106") comprise a further outer layer of reflective or a light-absorbing material and/or
wherein a color filter (108) is provided on the top multilayer interference reflector (106').

8. A display device (400) comprising
a plurality of optoelectronic devices (100) according to any of claims 1 to 7 provided side by side and configured to emit light of predetermined wavelength, and
wherein each pixel of the display (400) comprises at least one of the optoelectronic devices (100) according to any of claims 1 to 7.

9. A method of making an optoelectronic device (100) comprising the steps of:
a) depositing (601) a first multilayer interference reflector (105) over a semiconductor light-emitting component (101),
b) depositing (602) or patterning a semiconductor wavelength conversion material (103) over the first multilayer interference reflector (105) and in between contacts (7001) provided in the first multilayer interference reflector (105), and
c) depositing (603) of a second multilayer interference reflector (106) over the entire surface of the wavelength conversion material (103).

10. The method according to claim 9, further comprising the steps of:
making a plurality of the contacts (7001) in the first multilayer interference reflector (105) by damascene or dual damascene, and
providing at least a via (7002) between at least one of the contacts (7001) of the first multilayer interference reflector (105) and a contact (2002) of a wafer comprising driving elements, especially a CMOS wafer (2000), by damascene, dual damascene or etching followed by deposition.

11. The method according to claim 9 or 10, further comprising the step of:
depositing the first multilayer interference reflector layers (105) and/or the second multilayer interference reflector layers (106) by atomic layer deposition, chemical vapor deposition, or physical vapor deposition.

12. The method according to any of claims 9 to 11, further comprising the step of:
repeating the depositing step a) or c) on the first multilayer interference reflector (105) or the second multilayer interference reflector (106), respectively, at least one more time.

13. The method according to any of claims 9 to 12, further comprising the step of:
depositing or patterning the semiconductor wavelength conversion material (103) by lithography and/or laser-induced forward transition.

14. The method according to any of claims 9 to 13, further comprising the step of:
patterning the first multilayer interference reflector (105) and/or the second multilayer interference reflector (106) by lithography or dry etching to remove at least a part of the first multilayer interference reflector (105) and/or at least a part of the second multilayer interference reflector (106).

15. The method according to claim 10, further comprises steps for fabricating the semiconductor light-emitting component (101):
etching an LED wafer (200) to form mesas with a predetermined depth or less,
wherein the LED wafer (200) comprises a substrate (201), a transparent conductive oxide layer (205), an active layer (203) sandwiched between a first semiconductor layer (202) and a second semiconductor layer (204), wherein the transparent conductive oxide layer (205) is overlaying the substrate (201),
filling etched spaces on the LED wafer (200) with an oxide,
providing contacts (206) on the mesas on the LED wafer (200) by damascene, especially copper damascene,
transferring the LED wafer (200) to the wafer comprising driving elements, especially the CMOS wafer (2000) to form hybrid bonds, and
etching or planarizing the substrate of the LED wafer (200) to expose the transparent conductive oxide layer (205).

## Amended claims

### Amended claims in accordance with Rule 137(2) EPC.

1. An optoelectronic device (100) comprising,
a semiconductor light-emitting component (101) capable of emitting light at a first wavelength (102),
a cavity (107) filled with a semiconductor wavelength conversion material (103) disposed in a path of the light emitted by the semiconductor light-emitting component (101) for converting the first wavelength into a second wavelength,
a first multilayer interference reflector (105) provided at a bottom of the cavity (107) directed to the light-emitting component (101), wherein the first multilayer interference reflector (105) is configured to be transmitive for the first wavelength (102) and reflective for the second wavelength (104), and
a second multilayer interference reflector (106) provided at a top (106') and sidewalls (106") of the cavity (107), wherein the second multilayer interference reflector (106) is configured to be transmitive for the second wavelength (104) and to be reflective for the first wavelength (102),
wherein the multilayer interference reflector sidewalls (106") comprise a further outer layer of a light-absorbing material.

2. The device (100) according to claim 1,
wherein the wavelength conversion material (103) comprises quantum dots and/or elements of nanophosphor.

3. The device (100) according to claim 1 or 2,
wherein the first multilayer interference reflector (105) and the second multilayer interference reflector (106) are alternating layers of a high refractive index material (1051) and a low refractive index material (1052), wherein the high refractive index material (1051) comprises Al₂O₃ SiN, NbO₂, TaO₂, HfO₂ and/or TiOₓ and/or the low refractive index material (1052) comprises SiO₂ and/or Al₂O₃.

4. The device (100) according to any of claims 1 to 3,
wherein a number of alternating layer pairs (1051, 1052) is between 2 and 10, preferably between 3 and 8, most preferably between 4 and 6.

5. The device (100) according to any of claims 1 to 4,
wherein the cavity (107) has a lateral dimension less than 10 µm, preferably less than 5 pm, further preferably less than 3 pm.

6. The device (100) according to any of claims 1 to 5,
wherein a thickness of the first multilayer interference reflector (105) and/or of the second multilayer interference reflector (106) is between 500 nm to 1000 nm, and/or wherein a width of the second multilayer interference reflector (106) is between 2000 nm and 3000 nm.

7. The device (100) according to any of claims 1 to 6,
wherein the top multilayer interference reflector (106') and the multilayer interference reflector sidewalls (106") comprise a further outer layer of reflective or a light-absorbing material and/or
wherein a color filter (108) is provided on the top multilayer interference reflector (106').

8. A display device (400) comprising
a plurality of optoelectronic devices (100) according to any of claims 1 to 7 provided side by side and configured to emit light of predetermined wavelength, and wherein each pixel of the display (400) comprises at least one of the optoelectronic devices (100) according to any of claims 1 to 7.

9. A method of making an optoelectronic device (100) comprising the steps of:
a) depositing (601) a first multilayer interference reflector (105) over a semiconductor light-emitting component (101),
b) depositing (602) or patterning a semiconductor wavelength conversion material (103) over the first multilayer interference reflector (105) and in between contacts (7001) provided in the first multilayer interference reflector (105),
c) depositing (603) of a second multilayer interference reflector (106) over the entire surface of the wavelength conversion material (103); and
d) providing a further outer layer of light-absorbing material on the second multilayer interference reflector (106) deposited as sidewalls (106").

10. The method according to claim 9, further comprising the steps of:
making a plurality of the contacts (7001) in the first multilayer interference reflector (105) by damascene or dual damascene, and
providing at least a via (7002) between at least one of the contacts (7001) of the first multilayer interference reflector (105) and a contact (2002) of a wafer comprising driving elements, especially a CMOS wafer (2000), by damascene, dual damascene or etching followed by deposition.

11. The method according to claim 9 or 10, further comprising the step of:
depositing the first multilayer interference reflector layers (105) and/or the second multilayer interference reflector layers (106) by atomic layer deposition, chemical vapor deposition, or physical vapor deposition.

12. The method according to any of claims 9 to 11, further comprising the step of:
repeating the depositing step a) or c) on the first multilayer interference reflector (105) or the second multilayer interference reflector (106), respectively, at least one more time.

13. The method according to any of claims 9 to 12, further comprising the step of:
depositing or patterning the semiconductor wavelength conversion material (103) by lithography and/or laser-induced forward transition.

14. The method according to any of claims 9 to 13, further comprising the step of:
patterning the first multilayer interference reflector (105) and/or the second multilayer interference reflector (106) by lithography or dry etching to remove at least a part of the first multilayer interference reflector (105) and/or at least a part of the second multilayer interference reflector (106).

15. The method according to claim 10, further comprises steps for fabricating the semiconductor light-emitting component (101) :
etching an LED wafer (200) to form mesas with a predetermined depth or less,
wherein the LED wafer (200) comprises a substrate (201), a transparent conductive oxide layer (205), an active layer (203) sandwiched between a first semiconductor layer (202) and a second semiconductor layer (204), wherein the transparent conductive oxide layer (205) is overlaying the substrate (201),
filling etched spaces on the LED wafer (200) with an oxide,
providing contacts (206) on the mesas on the LED wafer (200) by damascene, especially copper damascene,
transferring the LED wafer (200) to the wafer comprising driving elements, especially the CMOS wafer (2000) to form hybrid bonds, and
etching or planarizing the substrate of the LED wafer (200) to expose the transparent conductive oxide layer (205).
